# EUROPEAN PATENT SPECIFICATION

(11) **EP 1 404 797 B1**
(45) Date of publication and mention of the grant of the patent: **28.02.2007**
(21) Application number: 02761045.0
(22) Date of filing: 08.07.2002
(51) Int. Cl.: C11D 7/32, C11D 7/50, G03F 7/42, H01L 21/306

(54) **AMMONIA-FREE ALKALINE MICROELECTRONIC CLEANING COMPOSITIONS WITH IMPROVED SUBSTRATE COMPATIBILITY**
AMMONIAK-FREIE ZUSAMMENSETZUNGEN MIT VERBESSERTER SUBSTRAT-KOMPATIBILITÄT ZUM REINIGEN VON MIKROELEKTRONISCHEN SUBSTRATEN
COMPOSITIONS DE NETTOYAGE ALCALINES SANS AMMONIAC PRESENTANT UNE MEILLEURE COMPATIBILITE AVEC LE SUBSTRAT DESTINEES A DES ELEMENTS MICRO-ELECTRONIQUES

(30) Priority: 09.07.2001 US 304036 P
(43) Date of publication of application: 07.04.2004
(73) Proprietor: MALLINCKRODT BAKER, Inc., St. Louis, MO 63134 (US)
(72) Inventor: HSU, Chien-Pin, Sherman, Basking Ridge, NJ 07920 (US)
(74) Representative: Bannerman, David Gardner
(86) International application number: PCT/US2002/021375
(87) International publication number: WO 2003/006598

(56) References cited:
- EP-A- 0 678 571
- EP-A- 0 690 483
- EP-A- 0 773 480
- WO-A-01/40425
- WO-A-02/33033
- WO-A-02/45148
- WO-A-94/05766
- WO-A-98/16330
- WO-A-98/30667
- US-A- 5 563 119
- US-A1- 2001 025 017
- US-B1- 6 225 030
- PATENT ABSTRACTS OF JAPAN vol. 2000, no. 16, 8 May 2001 (2001-05-08) & JP 2001 005201 A (NICHIGO MORTON CO LTD), 12 January 2001 (2001-01-12)

## Description

This invention relates to ammonia-free cleaning compositions for cleaning microelectronic substrates, and particularly to such cleaning compositions useful with and having improved compatibility with microelectronic substrates characterized by sensitive low₋ₖ and high₋ₖ dielectrics and copper metallization. The invention also relates to the use of such cleaning compositions for stripping photoresists, cleaning residues from plasma generated organic, organometallic and inorganic compounds, and cleaning residues from planarization processes, such as chemical mechanical polishing (CMP), as well as an additive in planarization slurry residues.

Many photoresist strippers and residue removers have been proposed for use in the microelectronics field as downstream or back end of the manufacturing line cleaners. WO 98/16330 discloses a semiconductor wafer cleaning composition containing TMAH and diethylene glycol. US 6,2,25,030 discloses a stripper composition containing TMAH and glycerol. WO 94/05766 discloses a cleaning composition for printed circuit boards containing TMAH and ethanolamine. US 5,563,119 discloses a stripper composition containing TMAH, triethanolamine and monoethanolamine. WO 01/40425 discloses a post CMP-cleaning composition containing TMAH and monoethanolamine. EP 678571 discloses a cleaning composition for microelectronics substrates containing TMAH and 1-amino-2-propanol. JP 11173475 discloses a photoresist stripping agent comprising tetraalkylammonium hydroxide and monoalkanolamine or dialkanolamine. In the manufacturing process a thin film of photoresist is deposited on a wafer substrate, and then circuit design is imaged on the thin film. Following baking, the unpolymerized resist is removed with a photoresist developer. The resulting image is then transferred to the underlying material, which is generally a dielectric or metal, by way of reactive plasma etch gases or chemical etchant solutions. The etchant gases or chemical etchant solutions selectively attack the photoresist-unprotected area of the substrate. As a result of the plasma etching process, photoresist, etching gas and etched material by-products are deposited as residues around or on the sidewall of the etched openings on the substrate.

Additionally, following the termination of the etching step, the resist mask must be removed from the protected area of the wafer so that the final finishing operation can take place. This can be accomplished in a plasma ashing step by the use of suitable plasma ashing gases or wet chemical strippers. Finding a suitable cleaning composition for removal of this resist mask material without adversely affecting, e.g., corroding, dissolving or dulling, the metal circuitry has also proven problematic.

As microelectronic fabrication integration levels have increased and patterned microelectronic device dimensions have decreased, it has become increasingly common in the art to employ copper metallizations, low₋ₖ and high₋ₖ dielectrics. These materials have presented additional challenges to find acceptable cleaner compositions. Many process technology compositions that have been previously developed for 'traditional' or 'conventional' semiconductor devices containing Al/SiO₂ or Al(Cu)/SiO₂ structures cannot be employed with copper metallized low₋ₖ or high₋ₖ dielectric structures. For example, hydroxylamine based stripper or residue remover compositions are successfully used for cleaning devices with Al metallizations, but are practically unsuitable for those with copper metallizations. Similarly, many copper metalllzed/low-k strippers are not suitable for Al metallized devices unless significant adjustments in the compositions are made.

Removal of these etch and/or ash residues following the etch and/or ashing process has proved problematic. Failure to completely remove or neutralize these residues can result in the absorption of moisture and the formation of undesirable materials that can cause corrosion to the metal structures. The circuitry materials are corroded by the undesirable materials and produce discontinuances in the circuitry wiring and undesirable increases in electrical resistance.

The current back end cleaners show a wide range of compatibility with certain, sensitive dielectrics and metallizations, ranging from totally unacceptable to marginally satisfactory. Many of the current strippers or residue cleaners are not acceptable for advanced interconnect materials such as porous and low₋ₖ dielectrics and copper metallizations. Additionally, the typical alkaline cleaning solutions employed are overly aggressive towards porous and low₋ₖ and high₋ₖ dielectrics and/or copper metallizations. Moreover, many of these alkaline cleaning compositions contain organic solvents that show poor product stability, especially at higher pH ranges and at higher process temperatures.

There is, therefore, a need for microelectronic cleaning compositions suitable for back end cleaning operations which compositions are effective cleaners and are applicable for stripping photoresists, cleaning residues from plasma process generated organic, organometallic and inorganic materials, and cleaning residues from planarization process steps, such as chemical mechanical polishing and the like. This invention relates to compositions that are effective in stripping photoresists, preparing/cleaning semiconductor surfaces and structures with good compatibility with advanced interconnect materials such as porous and low₋ₖ, and high₋ₖ dielectrics and copper metallizations.

It has been discovered that ammonia (NH₃) and ammonia-derived bases such as ammonium hydroxide and other salts (NH₄X,X=OH, carbonate, etc.) are capable of dissolving/corroding metals such as copper through complex formation. Thus they are poor choices to be used in semiconductor cleaning formulations when compatibility of low₋ₖ dielectrics (i.e., a ₖ value of 3 or less) or high₋ₖ dielectrics (i.e., a ₖ value of 20 or greater) and copper metallizations are required. These compounds can generate ammonia through equilibrium process. Ammonia can form complex with metals such as copper and result in metal corrosion/dissolution as set forth in the following equations.

NH₁X↔ NH₃+HX (Equation 1)

Cu+2NH₃→[Cu(NH₃)₂]⁺→[Cu(NH₃)₂]²⁺ (Equation 2)

Thus, ammonium hydroxide and ammonium salts can provide nucleophilic and metal-chelating ammonia (NH₃) through the equilibrium process described in Equation 1, particularly when other bases such as amines and alkanolamines are added. In the presence of oxygen, metals such as copper can be dissolved/corroded through complex formation with ammonia, as described in Equation 2, Such complex formation can further shift the equilibrium (Equation 1) to the right, and provide more ammonia, leading to higher metal dissolution/corrosion.

Generally, sensitive low₋ₖ dielectrics degrade significantly under strong alkaline conditions. Ammonia and ammonia derived bases also show poor compatibility with sensitive dielectrics, such as hydrogen silsesquioxane (HSQ) and methyl silsesquioxane (MSQ). Again, they can provide ammonia and/or other nucleophiles, and thus lead to reaction/degradation of sensitive dielectrics.

It has been discovered that non-ammonia producing strong base alkaline cleaning formulations containing non-nucleophilic, positively charged counter ions (such as tetraalkylammonium) in solvents that contain at least one corrosion inhibiting arm or moiety having at least two sites capable of complexing with metals, and at least one other organic co-solvent selected from dimethyl sufoxide, sulfolane and dimethylpiperidone show much improved compatibility with sensitive porous or low₋ₖ dielectrics and/or copper metallization. The preferred solvent matrices are resistant to strong alkaline conditions, due to steric hindrance effects and/or low or no reactivity to nucleophilic reactions (with respect to nucleophiles such as hydroxide ions). The improved dielectric compatibility is partially achieved due to the absence of undesirable nucleophiles in the compositions. Good compatibility with copper metallization is achieved by selective use of certain copper-compatible or 'corrosion inhibiting' solvents. These components can be formulated into semi-aqueous to practically non-aqueous (organic-solvent based) cleaning solutions or slurries.

The cleaning compositions of this invention comprise from about 0.05 to about 30wt.% of the non-ammonia producing strong base; from about 0.5 to about 99.95wt.% of the corrosion inhibiting solvent component having at least two sites capable of complexing with metals; up to about 95.45wt.% of at least one other organic co-solvent selected from dimethylsulfoxide, sulfolane and dimethylpiperidone; from about 0 to 40 wt.% steric hindered amines, alkanolamines or hydroxylamines; about 0 to 40wt.% organic or inorganic acids; about 0 to 40wt.% metal corrosion inhibitor compounds such as benzotriazole, catechol and the like; from about 0 to 5% wt.% surfactant, from about 0 to 10wt.% silicates, from about 0 to 5wt.% chelating agents, from about 0 to 10wt.% fluoride compounds, and water.

The novel back end cleaning composition of this invention will comprise one or more of any suitable non-ammonia producing strong base containing non-nucleophilic, positively charged counter ions and one or more of any suitable solvent stable under strong alkaline conditions and having a metal-corrosion inhibiting arm in the solvent compound. Among the suitable non-ammonia producing strong bases containing non-nucleophilic, positively charged counter ions suitable for use in the deaning compositions of this invention there may be mentioned tetraalkylammonium hydroxides or salts of the formula [(R)₄N⁺]ₚ [X^{-q}], where each R is independently a substituted or unsubstituted alkyl, preferably alkyl of from 1 to 22, and more preferably 1 to 6, carbon atoms (R≠ H); and X=OH or a suitable salt anion, such as carbonate and the like; p and q are equal and are integer of from 1 to 3. Suitable strong bases also include KOH and NaOH. Cleaning compositions containing the non-ammonia producing strong bases containing non-nucleophilic, positively charged counter ions show much improved compatibility with porous and low-κ dielectrics and copper metallization. Ammonia-free tetraalkylammonium hydroxides (TAAH) are very strong bases, yet they have been discovered to provide surprisingly improved compatibility with porous and low-κ dielectrics compared to cleaning compositions with ammonium hydroxide. Especially preferred are tetramethylammonium hydroxide, tetrabutylammonium hydroxide and choline hydroxide.

While previous attempts to control or inhibit metal corrosion have involved careful controlling of pH and/or using corrosion inhibiting compounds, such as benzotriazole (BT), at relatively low concentrations of < 2% by weight, it has been discovered that unexpected, significant improvement in controlling copper metal corrosion can be provided to the cleaning compositions of this invention when one or more "corrosion inhibiting solvent", i.e., a solvent compound that has at least two sites capable of complexing with metal is employed.

Preferred as such corrosion inhibiting solvents are compounds having two or more sites capable of complexing with a metal and having one of the two following general formulae:

W-(CR₁R₂)ₙ₁-X-[(CR₁R₂)ₙ₂-Y]ₓ

or

T-[(CR₃R₄)ₘ-Z]_{y}

where W and Y are each independently selected from =O, -OR, -O-C(O)-R, -C(O)-, -C(O)-R, -S, -S(O)-R,-SR, -S-C(O)-R, -S(O)₂-R, -S(O)₂, -N, -NH-R, -NR₁R₂, -N-C(O)-R, -NR₁-C(O)-R₂, -P(O), -P(O)-OR and -P(O)-(OR)₂; X is alkylene, cycloalkylene or cycloalkylene containing one or more hetero atoms selected from O, S, N and P atoms, and arylene or arylene containing one or more hetero atoms selected from O, S, N and P atoms; each R, R₁ and R₂ are each independently selected from hydrogen, alkyl, cycloalkyl or cycloalkyl containing one or more hetero atoms selected from O, S, N and P atoms, and aryl or aryl containing one or more hetero atoms selected from O, S, N and P atoms; each of n1 and n2 is independently an integer of from 0 to 6; and z is an integer of from 1 to 6 when X is alkylene, cycloalkylene or arylene; and z is an integer of from 0 to 5 when X is cycloalkylene containing one or more hetero atoms selected from O, S, N and P atoms or arylene containing one or more hetero atoms selected from O, S, N and P atoms; T is selected from -O, -S, -N and -P; Z is selected from hydrogen, -OR₅, -N(R₅)₂, and -SR₅; each of R₃, R₄ and R₅ are each independently selected from hydrogen, alkyl, cycloalkyl or cycloalkyl containing one or more hetero atoms selected from O, S, N and P atoms, and aryl or aryl containing one or more hetero atoms selected from O, S, N and P atoms; m is an integer of from 0 to 6 and y is an integer of from 1 to 6.

in the above definitions alkyl and alkylene are preferably of from 1 to 6 carbon atoms, more preferably of from 1 to 3 carbon atoms, cycloalkyl and cycloalkylene preferably contain from 3 to 6 carbon atoms, and aryl and arylene preferably contain from about 3 to 14 carbon atoms, more preferably from about 3 to 10 carbon atoms. Alkyl is preferably methyl, ethyl or propyl; alkylene is preferably methylene, ethylene or propylene; aryl is preferably phenyl; arylene is preferebly phenylene; hetero-substiituted cycloalkyl is preferably dioxyl, morpholinyl and pyrrolidinyl; and hetero-substituted aryl is preferably pyridinyl.

Some suitable examples are of such corrosion inhibiting solvents indude, for example, but are not limited to ethylene glycol, diethylene glycol, glycerol, diethylene glycol dimethyl ether, monoethanolamine, diethanolamine, triethanolamine, N,N-dimethylethanolamine, 1-(2-hydroxyethy<)-2-pynroHd!none, 4-(2-hydroxyethyl)morpholine, 2-(methylamino)ethanol, 2-amino-2-methyl-l-propanol, 1-amlno-2-propanol, 2-(2-aminoethoxy)-ethanol, N-(2-hydroxyethyl) acetamide, N-(2-hydroxyethyl) succinimide and 3-(diethylamino)-1,2-propanediol.

The cleaning compositions of this invention containing the non-ammonia producing strong bases can be formulated into aqueous, semi-aqueous or organic solvent-based compositions. The non-ammonia producing, strong bases containing non-nucleophilic, positively charged counter ions are used with corrosion inhibiting solvents in combination with one or more polar organic solvents resistant to strong bases and that do not contain unhindered nucleophiles, selected from dimethyl sulfoxide (DMSO), sulfolane (SFL), and dimethyl piperidone. The cleaning composition may also optionally contain organic or inorganic acids, preferably weak organic or inorganic acids, hindered amines, hindered alkanolamines, and hindered hydroxylamines. The cleaning compositions can also contain other metal corrosion inhibitors, such as benzotriazole, and aryl compounds containing 2 or more OH or OR groups, where R is alkyl or aryl, such as for example, catechol, pyrogallol, resorcinol and the like. The cleaning compositions may also contain any suitable surfactants, such as for example dimethyl hexynol (Surfynol-61), ethoxylated tetramethyl decynediol (Surfynol-465), polytetrafluoroethylene cetoxypropylbetaine (Zonyl FSK), (Zonyl FSH) and the like.

Any suitable metal ion-free silicate may be used in the compositions of the present invention. The silicates are preferably quaternary ammonium silicates, such as tetraalkyl ammonium silicate (including hydroxy- and alkoxy-containing alkyl groups generally of from 1 to 4 carbon atoms in the alkyl or alkoxy group). The most preferable metal ion-free silicate component is tetramethyl ammonium silicate. Other suitable metal ion-free silicate sources for this invention may be generated *in-situ* by dissolving any one or more of the following materials in the highly alkaline cleaner. Suitable metal ion-free materials useful for generating silicates in the cleaner are solid silicon wafers, silicic acid, colloidal silica, fumed silica or any other suitable form of silicon or silica. Metal silicates such as sodium metasilicate may be used but are not recommended due to the detrimental effects of metallic contamination on integrated circuits. The silicates may be present in the composition in an amount of from about 0 to 10 wt. %, preferably in an amount of from about 0.1 to about 5 wt. %.

The compositions of the present invention may also be formulated with suitable metal chelating agents to increase the capacity of the formulation to retain metals in solution and to enhance the dissolution of metallic residues on the wafer substrate. The chelating agent will generally be present in the compositions in an amount of from about 0 to 5 wt %, preferably from an amount of from about 0.1 to 2 wt. %. Typical examples of chelating agents useful for this purpose are the following organic acids and their isomers and salts; (ethylenedinitrilo)tetraacetic acid (EDTA), butylenediaminetetraacetic acid, (1,2-cyclohexylenedinitrilo)tetraacetic acid (CyDTA), diethylenetriaminepentaacetic acid (DETPA), ethylenediaminetetraproplonic acid, (hydroxyethyl)ethylenediaminetriacetic acid (HEDTA), N,N,N',N'-othylenediaminetetra(methylenephosphonic) acid (EDTMP), triathylenetetraminehexaacetic acid (TTHA), 1,3-diamino-2-hydroxypropane-N,N,N',N'-tetraacetic acid (DHPTA), methyliminodiacetic acid, propylenediaminetetraacetic acid, nitrolotriacetic acid (NTA), citric acid, tartaric acid, gluconic acid, saccharic acid, glyceric acid, oxalic acid, phthalic acid, maleic acid, mandelic acid, malonic acid, lactic acid, salicylic acid, catechol, gallic acid, propyl gallate, pyrogallol, 8-hydroxyquinoline, and cystelne. Preferred chelating agents are aminocarboxylic acids such as EDTA, CyDTA and aminophosphonic acids such as EDTMP.

The cleaning compositions may also optionally contain fluoride compounds in deaning composition, such as for example, tetramethylammonium fluoride, tetrabutylammonium fluoride, and ammonium fluoride. Other suitable fluorides include, for example fluoroborates, tetrabutylammonium fluoroborates, aluminum hexafluorides, antimony fluoride and the like. The fluoride components will be present in an amount of from 0 to 10 wt %, preferably from about 0.1 to 5 wt. %.

Thus, a wide range of processing/operating pH and temperatures can be used in effectively removing and cleaning photoresists, post plasma etch/ash residues, sacrifical light absorbing materials and anti-reflective coatings (ARC). It has also found that some of this type formulations are particularly effective to dean very difficult samples which contain tantalum in their structure, such as tantalum (Ta) or tantalum nitride barrier layers and tantalum oxide.

In the following portions of this application the following abbreviations are employed to designate the indicated components.
HEP=1-(2-hydroxyethyl)-2-pyrrolidinone
TMAH= 25% tetramethylammonium hydroxide
BT=benzotriazole
DMSO=dimethyl sulfoxide
TEA =triethanolamine
CyDTA=trans-1,2-cyclohexanediamine tetraacetic acid
SFL=sulfolane
EG=ethylene glycol
CAT=catchol
EDTMP=ethylonediamine tetra(mothylene phosphonic acid)
DMPD=dimethylpiperidone
TMAF=25% tetramethylammonium fluoride
BSA=benzenesulfonic acid
TMAS=10% tetramethylammonium silicate

Examples of these types of formulations are set forth in the following **Tables 1A, 1B,** and **1C** in which the amounts of the components are indicated in parts by weight.

**TABLE 1A**

| **COMPOSITIONS** | | | | | | | | |
|---|---|---|---|---|---|---|---|---|
| **COMPONENT** | **A** | **B** | **C** | **D** | **E** | **F** | **G** | **H** |
| HEP | 90 | | | | | | | 90 |
| H₂O | | 7 | 8 | 32 | 16 | 12 | | 8 |
| TMAH | 10.8 | 15 | 16 | 16 | 16 | 24 | 10 | 2.7 |
| BT | 0.11 | | | | | | | 0.11 |
| DMSO | | 16 | | | | | | |
| TEA | | 16 | 16 | 16 | | 24 | 10 | |
| CyDTA | | | 0.2 | 0.2 | | 0.3 | | |
| SFL | | | 16 | 16 | 24 | 24 | 40 | |
| EG | | | | | | | | |
| CAT | | | | | | | | |
| EDTMP | | | | | | | | |
| DMPD | | | | | | | | |

**TABLE 1B**

| **COMPOSITIONS** | | | | |
|---|---|---|---|---|
| **COMPONENT** | **I** | **J** | **K** | **L** |
| HEP | | | | |
| H₂O | 54 | 54 | 32 | 32 |
| TMAH | 45 | 36 | 4 | 16 |
| BT | | | | |
| DMSO | | | | |
| TEA | 36 | 36 | 16 | 15 |
| CyDTA | | | 0.4 | |
| SFL | | | | |
| EG | 54 | 54 | 48 | |
| CAT | | | 6 | |
| EDTMP | 0.36 | 0.36 | | 0.4 |
| DMPD | | | | 16 |

In **Table 1C** there are described variations of Compositions D and F of Table 1A with additional added optional components.

In **Tables 1A** and **1B** above, Compositions A, E, H, I, J and K do not fall within the scope of the invention and are present for comparative purposes.

**TABLE 1C**

| **COMPOSITIONS** | | | | | | | |
|---|---|---|---|---|---|---|---|
| **COMPOMENT** | **M** | **N** | **O** | **P** | **Q** | **R** | **S** |
| Composition D | 100 | 100 | 100 | | | | 100 |
| Composition F | | | | 100 | 100 | 100 | |
| TMAF | 2.5 | | | 2.5 | | | |
| TMAH | | 2 | | | 2 | | 2 |
| H₂O | | | | 10 | 10 | 10 | |
| BSA | | | 2 | | | 2 | |
| H₂SO₄ | | 0.5 | | | 0.5 | | 0.5 |
| TMAS | | | | | | | 1 |

The interlayer dielectric (ILD) etch rates for Compositions D and F of Table 1A and Compositions M through S of Table 1C against various dielectrics were evaluated by the following test procedure.

The film thickness of the wafer pieces is measured using a Rudolph Interferometer. The wafer pieces (with ILD material deposited on silicon wafers) were immersed in the designated cleaning compositions at the indicated temperature for 30 minutes, followed by rinsing with de-ionized water and drying under nitrogen flow/stream. The thickness was then measured again following the treatment and the etch rates were then calculated based on the change in film thickness, which are produced by the indicated treatments. The results are set forth in **Tables 2, 3, 4** and **5.**

**TABLE 2**

| **Dielectrics Etch rates (Å/min) at 45 °C (30min)** | | | | | | | | |
|---|---|---|---|---|---|---|---|---|
| Composition | CDO | Black Diamond | SiLK | Coral | FSG | TEOS | FOx -16 | SiN |
| D | 2 | 7 | <1 | <1 | <1 | <1 | ---- | <1 |
| F | 2 | 7 | <1 | <1 | <1 | <1 | ----- | <1 |

**TABLE 3**

| **Dielectrics Etch rates (Å/min) at 55 °C (30min)** | | | | | | | | |
|---|---|---|---|---|---|---|---|---|
| Composition | CDO | Black Diamond | SiLK | Coral | FSG | TEOS | FOx-16 | SiN |
| D | ----- | 29 | <1 | 6 | <1 | 1 | ------ | <1 |
| F | 2 | 25 | 3 | 4 | <1 | 4 | ------ | <1 |

**TABLE 4**

| **Dielectrics Etch rates (Å/min) at 65 °C (30min)** | | | | | | | | |
|---|---|---|---|---|---|---|---|---|
| Composition | CDO | Black Diamond | SiLK | Coral | FSG | TEOS | FOx-16 | SiN |
| D | 2 | 42 | 5 | 9 | <1 | 1 | ------ | <1 |
| F | 2 | 40 | 5 | 8 | <1 | 1 | ------ | <1 |

**TABLE 5**

| **Dielectrics Etch rates (Å/min) at 70 °C (30min)** | | | | |
|---|---|---|---|---|
| Composition | CDO | SiLK | Coral | TEOS |
| M | 5 | <1 | 12 | 3 |
| N | 5 | <1 | 14 | 3 |
| O | 4 | 2 | 12 | 2 |
| P | <1 | <1 | 5 | 1 |
| Q | <1 | <1 | 3 | <1 |
| R | 2 | <1 | 2 | <1 |
| S | <1 | <1 | <1 | 3 |

In **Tables 2, 3,4** and **5** the dielectric are as follows.
CDO=carbon doped oxide;
Black Diamond^{™}=brand of carbon doped oxide;
SiLK^{™}=organic polymer;
Coral^{™} =brand of carbon doped oxide;
FSG=fluorinated silicate glass;
TEOS=tetraethylorthosilicate;
FOx-16^{™}=flowable oxide (HSQ type); and
SiN=silicon nitride.

The following examples illustrate the excellent Cu compatibility as compared to the relatively poor Al compatibility of the compositions of this invention. The data is presented for Compositions D and F of **Table 1A** and Composition L of **Table 1B.**

The copper and aluminum etch rate for cleaning compositions of this invention are demonstrated by the etch rate data in the following **Tables 6** and **7**. The etch rate was determined utilizing the following test procedure. Pieces of aluminum or copper foil of approximately 13 x 50 mm were employed. The weight of the foil pieces was measured. After cleaning the foil pieces with 2-propanol, distilled water and acetone and the foil pieces are dried in a drying oven. The cleaned, dried foil pieces were then placed in loosely capped bottles of preheated cleaning compositions of the invention and placed in a vacuum oven for a period of from two to twenty-four hours at the indicated temperature. Following treatment and removal from the oven and bottles, the cleaned foils were rinsed with copious amounts of distilled water and dried in a drying oven for about 1 hour and then permitted to cool to room temperature, and then the etch rate determined based on weight loss or weight change.

**TABLE 6**

| **Metal etch rates (Å/min) at 55 °C (24 hours Study)** | | |
|---|---|---|
| Composition | Cu Etch rates | Al Etch Rates |
| D | <1 | >1,000 |
| F | <1 | >1,000 |

**TABLE 7**

| **Metal etch rates (Å/min) at 65°C (24 hours Study)** | | |
|---|---|---|
| Composition | Cu Etch rates | Al Etch Rates |
| D | <1 | >1,000 |
| F | <1 | >1,000 |
| L | 1 | |

The advantage of having the corrosion inhibiting solvents of this invention present in the composition is demonstrated by the following examples utilizing various corrosion inhibiting solvents, with comparable data for two comparison examples with no corrosion inhibiting solvent present. The Cu etch rate test was conducted in the same manner as described herein before and the results are set forth in **Table 8**.

**TABLE 8**

| **Cu etch rates (Å/hour) at 70-75 °C (oven temperature) (24 hours test)** | | | |
|---|---|---|---|
| Composition Components Parts by Weight | Inhibitor Identity | Inhibitor wt % | Cu Etch Rate (Å/hour) |
| 22:32 25%TMAH-DMSO | None | 0 | 220 |
| 22:16:16 25%TMAH-DMSO- 2-(methylamino) ethanol | 2-(methylamino)ethanol | 30 | <10 |
| 22:16:16 25%TMAH-DMSO- N,N-dimethylethanol amine | N,N-dimethylethanolamine | 30 | <10 |
| 22:16:16 25%TMAH-DMSO- 3-(Diethylamino)-1,2-propandiol | 3-(Diethylamino)-1,2-propandiol | 30 | <10 |
| | | | |
| 32:15:7 DMSO-25% TMAH-H₂O | None | 0 | 220 |
| 16:15:7:16 DMSO-25% TMAH-H_{2O}-triethanolamine | Triethanolamine | 30 | <10 |
| 16:15:7:16 DMSO-25% TMAH-H₂O-diethanolamine | Diethanolamine | 30 | <10 |
| 16:15:7:16 DMSO-25% TMAH-H₂O-monoethanol-amine | Monoethanolamine | 30 | <10 |
| 16:15:7:16 DMSO-25% TMAH-H₂O-HEP | HEP | 30 | <10 |
| 24:15:7:8 DMSO-25% TMAH-H₂O-triethanolamine | Triethanolamine | 15 | <10 |
| 24:15:7:8 DMSO-25% TMAH-H₂O-diethanolamine | Diethanolamine | 15 | <10 |
| 24:15:7:8 DMSO-25% TMAH-H₂O-monoethanol-amine | Monoethanolamine | 15 | <10 |
| 24:15:7:8 DMSO-25% TMAH-H₂O-HEP | HEP | 15 | <10 |

Similar Cu etch rates test were conducted with a formulation containing TMAH, DMSO and H₂O, with and without a corrosion inhibiting solvent and the etch rate data is presented in Table 9.

**TABLE 9**

| **Cu etch rates (Å/hour) at 70-75 °C (oven temperature) (24 hours test)** | | |
|---|---|---|
| Inhibitor Identity | Inhibitor wt % | Cu Etch Rate (Å/hour) |
| None | 0 | 140 |
| 2-amino-2-methyl-1-propanol | 30 | <10 |
| 1-amino-2-propanol | 30 | <10 |
| 2-(2-aminoethoxy)-ethanol | 30 | <10 |

Another series of Cu etch rate studies was conducted with a formulation of SFL and TMAH with and without a corrosion inhibiting solvent present in the formulation. The data for such test is presented in **Table 10.**

**TABLE 10**

| **Cu etch rates (A/hour) at 70-75 °C (oven temperature) (24 hours test)** | | | |
|---|---|---|---|
| Parts by weight Composition components | Inhibitor Identity | Inhibitor wt % | Cu Etch Rate (Å/hour) |
| 10:50 25%TMAH- SFL | None | 0 | 30 |
| 10:40:10 25%TMAH- SFL-TEA | TEA | 17 | <10 |

The following example demonstrates the superior compatibility of the non-ammonium strong bases of this invention, e.g. TMAH, in comparison to the ammonium bases, e.g. ammonium hydroxide (NH₄OH), with sensitive low-_{κ} dielectrics, such as hydrogen silsesquioxane (HSQ) type FOx-15^{™} flowable oxide. The test procedure is as follows. Wafer samples coated with dielectric films were immersed in a magnetically stirred wet chemical solution (stirring rate 300rpm), followed by isopropanol and distilled water rinses. The samples were then dried with a nitrogen stream before IR analysis

Transmittance IR spectra were obtained with a Nicolet 740 FTIR spectrometer using a deuterated triglycine sulfate (DTGS) detector. Spectra were acquired with 4 cm⁻¹ resolution and averaged over 32 scans. Fourier Transform Infrared (FTIR) analysis provides a way of monitoring the structural changes of HSQ dielectrics. The infrared absorption band assignments of typical deposited HSQ films are as follows.

| Assignments of Infrared Absorption Bands of HSQ Dielectric | |
|---|---|
| Absorption Frequencies (cm⁻¹) | **Band Assignment** |
| 2,250 | Si-H Stretch |
| 1,060-1,150 | Si-O-Si Stretch |
| 830-875 | H-Si-O hybrid vibration |

The content of Si-H bonds in HSQ films can be determined by measuring the peak areas of Si-H absorption bands at 2,250 cm⁻¹. The use of the silicon wafer's inherent absorption at 650-525 cm⁻¹ (from Si-Si lattice bonds and Si-C impurities) as the internal standard/reference resulted in quantitative IR analyses with good precision (relative standard deviation: 2-5 %).

**TABLE 11**

| **Compatibility with FOx-15 HSQ Low-κ Dielectrics** | | |
|---|---|---|
| Parts by weight Composition components | % Si-H Remaining after Treatment (by FTIR measurement) | % Film Thickness Remaining after treatment |
| 90:8:1:0.11; HEP-H₂O-NH₄OH-BT | 20 | 96 |
| 90:8:2.66:0.11; HEP-H₂O-TMAH-BT | 92.5 | 100 |

| | | |
|---|---|---|
| Original film thickness: 4,500 Å. | | |

The cleaning capability of compositions of this invention is illustrated in the following tests in which a microelectronic structure that comprised a wafer of the following via structure, namely photoresist/carbon doped oxide/silicon nitride/copper with the silicon nitride punched through to expose copper, was immersed in cleaning solutions for the indicated temperature and time, were then water rinsed, dried and then the cleaning determined by SEM inspection. The results are set forth in **Table 12**.

**TABLE 12**

| Composition and Process Condition | Cleaning Performance |
|---|---|
| Composition F, 75°C, 40min | 100% Clean; Removed all the PR (bulk PR and hardened, polymeric "via collar/fence") |
| Composition D, 75°C, 20min | 100% Clean; Removed all the PR (bulk PR and hardened, polymeric "via collar/fence") |
| Composition B, 75°C, 40min | 100% Clean; Removed all the PR (bulk PR and hardened, polymeric "via collar/fence") |

The same cleaning test was conducted on a microelectronic substrate that comprised a wafer of the following line structure, namely photoresist/tantalum nitride/FSG/copper. Two prior art commercial cleaning products were also tested for comparison purposes. The cleaning results are set forth in **Table 13.**

**TABLE 13**

| Composition and Process Condition | Cleaning Performance | Substrate Compatibility |
|---|---|---|
| Composition F, 75°C, 20min | 100% Clean; Removed all the PR (bulk PR and hardened, polymeric "fence") | 100% compatible with TaN and FSG |
| EKC-265^{™}, 75°C , 20min | Not Clean; Removed bulk PR, but hardened, polymeric "fence" remained | |
| ATMI ST-250, 30 °C, 20min (a fluoride-based stripper) | Not clean; nothing is changed | |

A similar cleaning test was conducted on a microelectronic structure that comprised a wafer of the following via structure, namely photoresist/carbon doped oxide/silicon nitride/copper without the silicon nitride punched through to expose copper. The results are set forth in **TABLE 14**.

**TABLE 14**

| Composition and Process Condition | Cleaning Performance |
|---|---|
| Composition D, 70°C, 20min | 100% Clean; Removed all the PR (bulk PR and hardened, polymeric "via collar/fence") |

A similar cleaning test was conducted on a microelectronic structure that comprised a wafer of the following via structure, namely pTEOS/Coral/SiN/Coral/SiN/copper. The results are set forth in **TABLE 15**.

**Table 15**

| Composition and Process Condition | Cleaning Performance | Substrate Compatibility |
|---|---|---|
| Composition B, 65°C, 20 min | 100% Clean; Removed all the residues | Compatible with Cu metal, dielectrics and etch stop/barrier layers. |

With the foregoing description of the invention, those skilled in the art will appreciate that modifications may be made to the invention without departing from the spirit and scope of thereof. Therefore, it is not intended that the scope of the invention be limited to the specific embodiments illustrated and described.

## Claims

1. A cleaning composition for cleaning microelectronic substrates, said cleaning composition comprising:
from about 0.05% to 30% by weight of one or more non-ammonia producing strong bases containing non-nucleophilic, positively charged counter ions;
from about 0.5 to about 99.95% by weight of one or more corrosion inhibiting solvent compounds, the or each corrosion inhibiting solvent compound having at least two sites capable of complexing with metals;
at least one other organic co-solvent selected from dimethyl sulfoxide, sulfolane, and dimethylpiperidone in an amount up to about 99.45% by weight; and
from about 0 to 40% by weight of a steric hindered amine or alkanolamine;
from about 0 to 40% by weight of an organic or inorganic acid;
from about 0 to 40% by weight of an other metal corrosion inhibitor compounds;
from about 0 to 5% by weight of a surfactant;
from about 0 to 10% by weight of a metal ion free silicate compound;
from about 0 to 5% by weight of a metal chelating agent;
from about 0 to 10% by weight of a fluoride compound; and
water.

2. A cleaning composition, of claim 1 wherein the non-ammonia producing strong base is a tetraalkylammonium hydroxide or salt thereof.

3. A cleaning composition of claim 2 wherein the tetraalkylammonium hydroxide or salt is a compound of the formula
[(R)₄ N⁺]ₚ[X^{-q}]
wherein each R is independently a substitured or unsubstituted alkyl group; × is OH or a salt anion; and p and q are equal and are integers of from 1 to 3.

4. A cleaning composition of claim 3 wherein R is an alkyl group containing 1 to 22 carbon atoms and X is OH.

5. A cleaning composition of claim 4 wherein R is an alkyl group of from 1 to 6 carbon atoms.

6. A cleaning composition of any preceding claim wherein the corrosion inhibiting solvent compound is a compound having the formula:
W-(CR₁R₂)ₙ₁-X-[(CR₁R₂)ₙ₂-Y]_{z}
or
T-[(CR₃R₄)ₘ-Z]_{y}
where W and Y are each independently selected from =O, -OR, -O-C(O)-R,-C(O)-, -C(O)-R, -S, -S(O)-R, -SR, -S-C(O)-R, -S(O)₂-R, -S(O)₂, -N, -NH-R, -NR₁R₂, -N-C(O)-R, -NR₁-C(O)-R₂, -P(O), -P(O)-OR and -P(O)-(OR)₂; X is selected from alkylene, cycloalkylene or cycloalkylene containing one or more hetero atoms selected from O, S, N and P atoms, and arylene or arylene containing one or more hetero atoms selected from O, S, N and P atoms; each R, R₁ and R₂ are each independently selected from hydrogen, alkyl, cycloalkyl or cycloalkyl containing one or more hetero atoms selected from O, S, N and P atoms, and aryl or aryl containing one or more hetero atoms selected from O, S, N and P atoms; each of n1 and n2 is independently an integer of from 0 to 6; and z is an integer of from 1 to 6 when X is alkylene, cycloalkylene or arylene; and z is an integer of from 0 to 5 when X is cycloalkylene containing one or more hetero atoms selected from O, S, N and P atoms or arylene containing one or more hetero atoms selected from O, S, N and P atoms; T is selected from -O, -S, -N and -P; Z is selected from hydrogen, -OR₅, -N(R₅)₂, and -SR₅; each of R₃, R₄ and R₅ are each independently selected from hydrogen, alkyl, cycloalkyl or cycloalkyl containing one or more hetero atoms selected from O, S, N and P atoms, and aryl or aryl containing one or more hetero atoms selected from O, S, N and P atoms; m is an integer of from 0 to 6 and y is an integer of from 1 to 6.

7. A cleaning composition of Claim 6 when appended to claim 5 wherein each of R₁ to R₅ is an alkyl group having from 1 to 6 carbon atoms or an aryl group having from 3 to 14 carbon atoms.

8. A deaning composition of any one of claims 1 to 5 wherein the corrosion inhibiting solvent is selected from ethylene glycol, diethylene glycol, glycerol, diethylene glycol dimethyl ether, monoethanolamine, diethanolamine, triethanolamine, N,N-dimethylethanolamine, 1-(2-hydroxyethyl)-2-pyrrolidinone, 4-(2-hydroxyethyl)morpholine, 2-(methylamino)ethanol, 2-amino-2-methyl-1-propanol, 1-amino-2-propanol, 2-(2-aminoethoxy)-ethanol, N-(2-hydroxyethyl) acetamide, N-(2-hydroxyethyl) succinimide and 3-(diethytamino)-1,2-propanediol.

9. A cleaning composition of claim 1 comprising tetramethylammonium hydroxide, triethanolamine, trans-1,2-cyclohexanediamine tetraacetic acid, sulfolane and water.

10. A deaning composition of claim 1 comprising tetramethylammonium hydroxide, dimethyl sulfoxide, triethanolamine and water.

11. A cleaning composition of claim 1 comprising tetramethylammonium hydroxide, triethanolamine, ethylene glycol, ethylenediamine tetra(methylene phosphonic acid) and water.

12. A process for deaning a microelectronic substrate having at least one of a porous dielectric, a low-κ or high-κ dielectric and copper metallization, the process comprising contacting the substrate with a cleaning composition for a time sufficient to dean the substrate, wherein the cleaning composition comprises:
from about 0.05% to 30% by weight of one or more non-ammonia producing strong base containing non-nucleophilic, positively charged counter ions;
from about 0.5 to about 99.95% by weight of one or more corrosion inhibiting solvent compounds, said corrosion inhibiting solvent compound having at least two sites capable of complexing with metals;
at least one other organic co-solvent selected from dimethyl sulfoxide, sulfolane, and dimethylpiperidone in an amount up to about 99.45% by weight; and
from about 0 to 40% by weight a steric hindered amine or alkanolamine;
from about 0 to 40% by weight an organic or inorganic acid;
from about 0 to 40% by weight of an other metal corrosion inhibitor compounds;
from about 0 to 5 % by weight a surfactant;
from about 0 to 10% by weight of a metal ion free silicate compound;
from about 0 to 5 % by weight of a metal chelating agent;
from about 0 to 10% by weight of a fluoride compound; and
water.

13. A process of claim 12 wherein the non-ammonia producing strong base is a tetraalkylammonium hydroxide or salt thereof.

14. A process of claim 13 wherein the tetraalkylammonium hydroxide or salt is a compound of the formula
[(R)₄ N⁺]ₚ[X^{-q}]
wherein each R is independently a substituted or unsubstituted alkyl group; X is OH or a salt anion; and p and q are equal and are integers of from 1 to 3.

15. A process of claim 14 wherein R is an alkyl group containing 1 to 22 carbon atoms and X is OH or carbonate.

16. A process of claim 14 wherein R is an alkyl group of from 1 to 6 carbon atoms.

17. A process of Claim 12, 13, 14 or 16 wherein the corrosion inhibiting solvent compound is a compound selected from the formulae:
W-(CR₁R₂)ₙ₁-X-[(CR₁R₂)ₙ₂-Y]_{z}
or
T-[(CR₃R₄)ₘ-Z]_{y}
where W and Y are each independently selected from =O, -OR, -O-C(O)-R, - C(O)-, -C(O)-R, -S, -S(O)-R, -SR, -S-C(O)-R, -S(O)₂-R, -S(O)₂, -N, -NH-R, -NR₁R₂, -N-C(O)-R, -NR₁-C(O)-R₂, -P(O), -P(O)-OR and -P(O)-(OR)₂; X is selected from alkylene, cycloalkylene or cycloalkylene containing one or more hetero atoms selected from O, S, N and P atoms, and arylene or arylene containing one or more hetero atoms selected from O, S, N and P atoms; each R, R₁ and R₂ are each independently selected from hydrogen, alkyl, cycloalkyl or cycloalkyl containing one or more hetero atoms selected from O, S, N and P atoms, and aryl or aryl containing one or more hetero atoms selected from O, S, N and P atoms; each of n1 and n2 is independently an integer of from 0 to 6; and z is an integer of from 1 to 6 when X is alkylene, cycloalkylene or arylene; and z is an integer of from 0 to 5 when X is cycloalkylene containing one or more hetero atoms selected from O, S, N and P atoms or arylene containing one or more hetero atoms selected from O, S, N and P atoms; T is selected from -O, -S, -N and -P; Z is selected from hydrogen, -OR₅, -N(R₅)₂, and -SR₅; each of R₃, R₄ and R₅ are each independently selected from hydrogen, alkyl, cycloalkyl or cycloalkyl containing one or more hetero atoms selected from O, S, N and P atoms, and aryl or aryl containing one or more hetero atoms selected from O, S, N and P atoms; m is an integer of from 0 to 6 and y is an integer of from 1 to 6.

18. A process of claim 17 when appended to claim 15 wherein each of R₁ to R₅ is an alkyl group having from 1 to 6 carbon atoms or an aryl group having from 3 to 14 carbon atoms.

19. A process of Claim 12, 13, 14, 15 or 16 wherein the corrosion inhibiting solvent is selected from ethylene glycol, diethylene glycol, glycerol, diethylene glycol dimethyl ether, monoethanolamine, diethanolamine, triethanolamine, N,N-dimethylethanolamine, 1-(2-hydroxyethyl)-2-pyrrolidinone, 4-(2-hydroxyethyl)morpholine, 2-(methylamino)ethanol, 2-amino-2-methyl-1-propanol, 1-amino-2-propanol, 2-(2-aminoethoxy)-ethanol, N-(2-hydroxyethyl) acetamide, N-(2-hydroxyethyl) succinimide and 3-(diethylamino)-1,2-propanediol.

20. A process of claim 12 wherein the cleaning composition comprises tetramethylammoniun hydroxide, triethanolamine, trans-1,2-cyclohexanediamine tetraacetic acid, sulfolane and water.

21. A process of claim 12 comprising tetramethylammonium hydroxide, dimethyl sulfoxide, triethanolamine and water.

22. A process of claim 12 wherein the cleaning composition comprising tetramethylammonium hydroxide, triethanolamine, ethylene glycol, ethylenediamine tetra(methylene phosphonic acid) and water.

## Patentansprüche

1. Reinigungsmittel zur Reinigung mikroelektronischer Substrate, wobei das Reinigungsmittel enthält:
von etwa 0,05 bis 30 Gewichtsprozent einer oder mehrerer Nicht-Ammoniak erzeugender starker Base(n), die Nicht-Nucleophile, positiv geladene Gegenionen enthält oder enthalten;
von etwa 0,5 bis etwa 99,95 Gewichtsprozent einer oder mehrerer korrosionshemmender Lösungsmittelverbindung(en), wobei die oder jede korrosionshemmende Lösungsmittelverbindung wenigstens zwei Stellen besitzen, die mit Metallen einen Komplex bilden können;
wenigstens ein anderes organisches Verschnittmittel ausgewählt aus Dimethylsulfoxid, Sulfolan und Dimethylpiperidon in einer Menge bis zu etwa 99,45 Gewichtsprozent; und
von etwa 0 bis 40 Gewichtsprozent eines sterisch gehinderten Amins oder Alkanolamins;
von etwa 0 bis 40 Gewichtsprozent einer organischen oder anorganischen Säure;
von etwa 0 bis 40 Gewichtsprozent einer anderen metallkorrosionshemmenden Verbindung;
von etwa 0 bis 5 Gewichtsprozent eines oberflächenaktiven Mittels;
von etwa 0 bis 10 Gewichtsprozent einer metallionenfreien Silikatverbindung;
von etwa 0 bis 5 Gewichtsprozent eines Metall-Chelatbildners;
von etwa 0 bis 10 Gewichtsprozent einer Fluoridverbindung; und Wasser.

2. Reinigungsmittel nach Anspruch 1, wobei die Nicht-Ammoniak erzeugende starke Base ein Tetraalkylammoniumhydroxid oder ein Salz hiervon ist.

3. Reinigungsmittel nach Anspruch 2, wobei das Tetraalkylammoniumhydroxid oder Salz hiervon eine Verbindung der Formel folgt
└(*R*)₄*N*⁺┘*ₚ*└*X^{q}*┘
ist, in der jedes R, unabhängig voneinander eine substituierte oder unsubstituierte Alkylgruppe; X OH oder ein Salzanion; und p und q gleich und ganze Zahlen von 1 bis 3 sind.

4. Reinigungsmittel nach Anspruch 3, wobei R eine Alkylgruppe mit 1 bis 22 Kohlenstoffatomen und X OH sind.

5. Reinigungsmittel nach Anspruch 4, wobei R eine Alkylgruppe mit ein bis 6 Kohlenstoffatomen ist.

6. Reinigungsmittel nach einem der vorstehenden Ansprüche, worin die korrosionshemmende Lösungsmittelverbindung eine Verbindung der Formel
*W* -(*CR*₁*R*₂*)*_{*n*1}*-X-*[(*CR*₁*R*₂)_{*n*2}*-Y*]*_{Z}*
oder
*T-* [(*CR*₃*R*₄)*ₘ*-Z]*_{Y}*
ist, wobei W und Y jeweils unabhängig voneinander aus =O, -OR, -O-C(O)-R, -C(O)-, -C(O)R, -S, -S(O)-R, -SR, -S-C(O)-R, -S(O)₂-R, -S(O)₂, -N, -NH-R, -NR₁R₂, -N-C(O)-R, -NR₂-C(O)-R₂, -P(O), -P(O)-OR und -P(O)-(OR)₂ sind; ausgewählt ist von Alkylen, Cycloalkylen oder Cycloalkylen, das ein oder mehrere Heteroatome ausgewählt aus O, S, N und P-Atomen, und Arylen oder Arylen enthaltend eine oder mehrere Heteroatome ausgewählt aus O, S, N und P-Atomen sind; jedes R, R₁ und R₂ unabhängig voneinander aus Wasserstoff, Alkyl, Cycloalkyl oder Cycloalkyl mit einem oder mehreren Heteroatomen ausgewählt aus O, S, N und P-Atomen, und Aryl oder Aryl enthaltend ein oder mehrere Heteroatome ausgewählt aus O, S, N und P-Atomen sind; jedes n1 und n2 unabhängig voneinander eine ganze Zahl von 0 bis 6 ist; und z eine ganze Zahl von 1 bis 6 ist, wenn X Alkylen, Cycloalkylen oder Arylen ist; und z eine ganze Zahl von 0 bis 5 ist, wenn X Cycloalkylen, enthaltend ein oder mehrere Heteroatom(e) ausgewählt aus O, S, N und P-Atomen oder Arylen enthaltend ein oder mehrere Heteroatome ausgewählt aus O, S, N und P-Atomen ist; T ausgewählt ist aus -O, -S, -N und -P; Z ausgewählt ist aus Wasserstoff, -OR₅, -N(R₅)₂, und -SR₅; jedes R₃, R₄ und R₅ unabhängig voneinander ausgewählt ist aus Wasserstoff, Alkyl, Cycloalkyl oder Cycloalkyl, enthaltend ein oder mehrere Heteroatom(e) ausgewählt aus 0, S, N und P-Atomen und Aryl oder Aryl, enthaltend eine oder mehrere Heteroatom(e) ausgewählt aus O, S, N und P-Atomen ist; m eine ganze Zahl von 0 bis 6 ist und y eine ganze Zahl von 1 bis 6 ist.

7. Reinigungsmittel nach Anspruch 6, rückbezogen auf Anspruch 5, wobei jedes R₁ bis R₅ eine Alkylgruppe mit 1 bis 6 Kohlenstoffatomen oder eine Arylgruppe 3 bis 14 Kohlenstoffatomen ist.

8. Reinigungsmittel nach einem der Ansprüche 1 bis 5, wobei das korrosionshemmende Lösungsmittel ausgewählt ist aus Ethylenglycol, Dieethylenglycol, Glyzerin, Diethylenglycoldimethylether, Monoethanolamin, Diethanolamin, Triethanolamin, N,N-Dimethylethanolamin, 1-(2-Hydroxyethyl)-2-pyrrolidon, 4-(2-Hydroxyethyl)morpholin, 2-(Methylamino)ethanol, 2-Amino-2-methyl-1-propanol, 1-Amino-2-propanol, 2-(2-Aminoethoxy)-ethanol, N-(2-Hydroxyethyl)acetamid, N-(2-Hydroxyethyl)succinimid und 3-(Diethylamino)-1, 2-propandiol.

9. Reinigungsmittel nach Anspruch 1, enthaltend Tetramethylammoniumhydroxid, Triethanolamin, trans-1,2-Cyclohexandiamintetraessigsäure,Sulfolan und Wasser.

10. Reinigungsmittel nach Anspruch 1, enthaltend Tetramethylammoniumhydroxid, Dimethylsulfoxid, Triethanolamin und Wasser.

11. Reinigungsmittel nach Anspruch 1, enthaltend Tetramethylammoniumhydroxid, Triethanolamin, Ethylenglycol, Ethylendiamin-tetra(methylenphosphonsäure) und Wasser.

12. Verfahren zur Reinigung eines mikroelektronischen Substrats, das wenigstens eine poröse dielektrische, eine niedrig-κ- oder hoch-κ-dielektrische und Kupfer-Metallisierung hat, wobei das Verfahren umfasst: man bringt das Substrat mit einem Reinigungsmittel genügend lange Zeit zur Reinigung des Substrats in Kontakt, wobei das Reinigungsmittel enthält:
von etwa 0,05 bis 30 Gewichtsprozent einer oder mehrerer Nicht-Ammoniak erzeugenden starken Base(n), die Nicht-Nucleophile, positiv geladene Gegenionen enthält oder enthalten;
von etwa 0,5 bis etwa 99,95 Gewichtsprozent einer oder mehrerer korrosionshemmenden Lösungsmittelverbindung(en), wobei die oder jede korrosionshemmende Lösungsmittelverbindung wenigstens zwei Stellen besitzen, die mit Metallen einen Komplex bilden können;
wenigstens ein anderes organisches Verschnittmittel ausgewählt aus Dimethylsulfoxid, Sulfolan, und Dimethylpiperidone in einer Menge bis zu etwa 99,45 Gewichtsprozent; und
von etwa 0 bis 40 Gewichtsprozent eines sterisch gehinderten Amins oder Alkanolamins;
von etwa 0 bis 40 Gewichtsprozent einer organischen oder anorganischen Säure;
von etwa 0 bis 40 Gewichtsprozent einer anderen metallkorrosionshemmenden Verbindung;
von etwa 0 bis 5 Gewichtsprozent eines oberflächenaktiven Mittels;
von etwa 0 bis 10 Gewichtsprozent einer metallionenfreien Silikatverbindung;
von etwa 0 bis 5 Gewichtsprozent eines Metall-Chelatbildendeners;
von etwa 0 bis 10 Gewichtsprozent einer Fluoridverbindung; und
Wasser.

13. Verfahren nach Anspruch 12, wobei die Nicht-Ammoniak erzeugende starke Base ein Tetraalkylammonium-hydroxid oder ein Salz hiervon ist.

14. Verfahren nach Anspruch 13, wobei das Tetraalkylammonium-hydroxid oder sein Salz eine Verbindung der Formel
└(*R*)₄*N*⁺┘*ₚ*└*X^{q}*┘
ist, in der jedes R, unabhängig voneinander eine substituierte oder unsubstituierte Alkylgruppe; X OH oder ein Salzanion; und p und q gleich und ganze Zahlen von 1 bis 3 sind.

15. Verfahren nach Anspruch 14, wobei R eine Alkylgruppe mit 1 bis 22 Kohlenstoffatomen und X OH oder Carbonat ist.

16. Verfahren nach Anspruch 14, wobei R eine Alkylgruppe mit 1 bis 6 Kohlenstoffatomen ist.

17. Verfahren nach den Ansprüchen 12, 13, 14 oder 16, wobei die korrosionshemmende Lösungsmittelverbindung eine Verbindung der Formel
*W* -(*CR*₁*R*₂)_{*n*1}-*X*-[(*CR*₁*R*₂)_{*n*2} *-Y*]*_{Z}*
oder
*T -* [(*CR*₃*R*₄)*ₘ* - Z]*_{Y}*
ist, wobei W und Y jeweils unabhängig voneinander ausgewählt sind aus =O, -OR, -O-C(O)-R, -C(O)-, -C(O)R, -S, -S(O)-R, -SR, -S-C(O)-R, -S(O)₂-R, -S(O)₂, -N, -NH-R, -NR₁R₂, -N-C(O)-R, -NR₁-C(O)-R₂, -P(O), -P(O)-OR und -P(O)-(OR)₂; X ausgewählt ist aus Alkylen, Cycloalkylen oder Cycloalkylen, das ein oder mehrere Heteroatome besitzt ausgewählt aus O, S, N und P-Atomen, und Arylen oder Arylen, enthaltend eine oder mehrere Heteroatome ausgewählt aus O, S, N und P-Atomen; jedes R, R₁ und R₂ unabhängig voneinander aus Wasserstoff, Alkyl, Cycloalkyl oder Cycloalkyl mit einem oder mehreren Heteroatomen ausgewählt aus O, S, N und P-Atomen, und Aryl oder Aryl enthaltend ein oder mehrere Heteroatome ausgewählt aus O, S, N und P-Atomen; jedes n1 und n2 unabhängig voneinander eine ganze Zahl von 0 bis 6 ist; und z eine ganze Zahl von 1 bis 6 ist, wenn X Alkylen, Cycloalkylen oder Arylen ist; und z eine ganze Zahl von 0 bis 5 ist, wenn X Cycloalkylen, enthaltend ein oder mehrere Heteroatom(e) ausgewählt aus O, S, N und P-Atomen oder Arylen enthaltend ein oder mehrere Heteroatome ausgewählt aus O, S, N und P-Atomen ist; T ausgewählt ist aus -O, -S, -N und -P; Z ausgewählt ist aus Wasserstoff, -OR₅, -N(R₅)₂, und -SR₅; jedes R₃, R₄ und R₅ unabhängig voneinander ausgewählt ist aus Wasserstoff, Alkyl, Cycloalkyl oder Cycloalkyl, enthaltend ein oder mehrere Heteroatom(e) ausgewählt aus O, S, N und P-Atomen, und Aryl oder Aryl, enthaltend eine oder mehrere Heteroatom(e) ausgewählt aus O, S, N und P-Atomen ist; m eine ganze Zahl von 0 bis 6 ist und y eine ganze Zahl von 1 bis 6 ist.

18. Verfahren nach Anspruch 17 bezogen Anspruch 15, wobei jedes R₁ bis R₅ eine Alkylgruppe mit 1 bis 6 Kohlenstoffatomen oder eine Arylgruppe mit 3 bis 14 Kohlenstoffatomen ist.

19. Verfahren nach Anspruch 12, 13, 14, 15 oder 16, wobei das korrosionshemmende Lösungsmittel ausgewählt ist aus Ethylenglycol, Dieethylenglycol, Glyzerin, Diethylenglycoldimethylether, Monoethanolamin, Diethanolamin, Triethanolamin, N,N-Dimethylethanolamin, 1-(2-Hydroxyethyl)-2-pyrrolidon, 4-(2-Hydroxyethyl)morpholin, 2-(Methylamino)ethanol, 2-Amino-2-methyl-1-propanol, 1-Amino-2-propanol, 2-(2-Aminoethoxv)-ethanol, N-(2-Hydroxyethyl)acetamid, N-(2-Hydroxyethyl)succinimid und 3-(Diethylamino)-1,2-propandiol.

20. Verfahren nach Anspruch 12, wobei das Reinigungsmittel Tetramethylammoniumhydroxid, Triethanolamin, trans-1,2-Cyclohexandiamintetraessigsäure, Sulfolan und Wasser umfasst.

21. Verfahren nach Anspruch 12, enthaltend Tetramethylammoniumhydroxid, Dimethylsulfoxid, Triethanolamin und Wasser.

22. Verfahren nach Anspruch 12, wobei das Reinigungsmittel Tetramethylammoniumhydroxid, Triethanolamin, Ethylenglycol, Ethylendiamin-tetra(methylenphosphonsäure) und Wasser enthält.

## Revendications

1. Composition de nettoyage pour nettoyer des substrats microélectroniques, ladite composition de nettoyage comprenant :
d'environ 0,05% à 30% en poids d'une ou plusieurs base(s) forte(s) non productrice(s) d'ammoniac contenant des contre-ions chargés positivement non nucléophiles ;
d'environ 0,5 à environ 99,95% en poids d'un ou plusieurs composé(s) de solvant inhibant la corrosion, le ou chaque composé de solvant inhibant la corrosion ayant au moins deux sites capables de se complexer avec des métaux ;
au moins un autre co-solvant organique choisi parmi le diméthylsulfoxyde, le sulfolane, et la diméthylpipéridone dans une quantité jusqu'à environ 99,45% en poids ; et
d'environ 0 à 40% en poids d'une amine ou d'une alkanolamine à encombrement stérique ;
d'environ 0 à 40% en poids d'un acide organique ou inorganique ;
d'environ 0 à 40% en poids d'un autre composé inhibiteur de la corrosion des métaux ;
d'environ 0 à 5% en poids d'un agent tensioactif ;
d'environ 0 à 10% en poids d'un composé silicate sans ions métal ;
d'environ 0 à 5% en poids d'un agent chélateur des métaux ;
d'environ 0 à 10% en poids d'un composé fluorure ; et
de l'eau.

2. Composition de nettoyage selon la revendication 1, dans laquelle la base forte non productrice d'ammoniac est l'hydroxyde de tétraalkylammonium ou un sel de celui-ci.

3. Composition de nettoyage selon la revendication 2, dans laquelle l'hydroxyde de tétraalkylammonium ou le sel est un composé ayant la formule
[(R)₄N⁺]ₚ[X^{-q}]
où chaque R est indépendamment un groupement alkyle substitué ou non substitué ; X est OH ou un anion sel ; et p et q sont égaux et sont des entiers de 1 à 3.

4. Composition de nettoyage selon la revendication 3, dans laquelle R est un groupement alkyle contenant 1 à 22 atomes de carbone et X est OH.

5. Composition de nettoyage selon la revendication 4, dans laquelle R est un groupement alkyle de 1 à 6 atomes de carbone.

6. Composition de nettoyage selon l'une quelconque des revendications précédentes dans laquelle le composé solvant inhibant la corrosion est un composé ayant la formule :
W-(CR₁R₁)ₙ₁-X-[(CR₁R₂)ₙ₂-Y]ₓ
ou
T-[(CR₃R₄)ₘ-Z]_{y}
où W et Y sont chacun indépendamment choisis parmi =O, -OR, -O-C(O)-R, -C(O)-, -C(O)-R, -S, -S(O)-R, -SR, -S-C(O)-R, -S(O)₂-R, -S(O)₂, -N, -NH-R, -NR₁R₂, -N-C(O)-R, -NR₁-C(O)-R₂, -P(O), -P(O)-OR, et -P(O)-(OR)₂ ; X est choisi parmi un alkylène, un cycloalkylène ou un cycloalkylène contenant un ou plusieurs hétéoatomes choisis parmi les atomes de O, S, N et P, et un arylène ou un arylène contenant un ou plusieurs hétéoatomes choisis parmi les atomes de O, S, N et P ; chaque R, R₁ et R₂ sont chacun indépendamment choisis parmi l'hydrogène, un alkyle, un cycloalkyle ou un cycloalkyle contenant un ou plusieurs hétéoatomes choisis parmi les atomes de O, S, N et P, et un aryle ou un aryle contenant un ou plusieurs hétéoatomes choisis parmi les atomes de O, S, N et P ; chacun de n1 et n2 est indépendamment un entier de 0 à 6 ; et z est un entier de 1 à 6 lorsque X est un alkylène, un cycloalkylène ou un arylène ; et z est un entier de 0 à 5 lorsque X est un cycloalkylène contenant un ou plusieurs hétéoatomes choisis parmi les atomes de O, S, N et P ou un arylène contenant un ou plusieurs hétéoatomes choisis parmi les atomes de O, S, N et P ; T est choisi parmi -0, -S, -N et -P ; Z est choisi parmi l'hydrogène, -OR₅, -N(R₅)₂, et -SR₅ ; chacun de R₃, R₄ et R₅ sont chacun indépendamment choisis parmi l'hydrogène, un alkyle, un cycloalkyle ou un cycloalkyle contenant un ou plusieurs hétéoatomes choisis parmi les atomes de O, S, N et P, et un aryle ou un aryle contenant un ou plusieurs hétéoatomes choisis parmi les atomes de O, S, N et P ; m est un entier de 0 à 6 et y est un entier de 1 à 6.

7. Composition de nettoyage selon la revendication 6 lorsqu'elle est annexée à la revendication 5 dans laquelle chacun de R₁ à R₅ est un groupement alkyle ayant de 1 à 6 atomes de carbone ou un groupement aryle ayant de 3 à 14 atomes de carbone.

8. Composition de nettoyage selon l'une quelconque des revendications 1 à 5 dans laquelle le solvant inhibant la corrosion est choisi parmi l'éthylène glycol, le diéthylène glycol, le glycérol, le diéthylène glycol diméthyle éther, la monoéthanolamine, la diéthanolamine, la triéthanolamine, la N,N-diméthyléthanolamine, la 1-(2-hydroxyméthyl)-2-pyrrolidone, la 4-(2-hydroxyéthyl)morpholine, le 2-(méthylamino)éthanol, le 2-amino-2-méthyl-1-propanol, le 1-amino-2-propanol, le 2-(2-aminoéthoxy)éthanol, le N-(2-hydroxyéthyl)acétamide, le N-(2-hydroxyéthyl)succinimide et le 3-(diéthylamino)-1,2-propanediol.

9. Composition de nettoyage selon la revendication 1 comprenant de l'hydroxyde de tétraméthylammonium, de la triéthanolamine, de l'acide trans-1,2-cyclohexanediamine tétraacétique, du sulfolane et de l'eau.

10. Composition de nettoyage selon la revendication 1 comprenant de l'hydroxyde de tétraméthylammonium, du diméthyle sulfoxyde, de la triéthanolamine et de l'eau.

11. Composition de nettoyage selon la revendication 1 comprenant de l'hydroxyde de tétraméthylammonium, de la triéthanolamine, de l'éthylène glycol, de l'acide éthylènediamine tétra(méthylène phosphonique) et de l'eau.

12. Procédé pour nettoyer un substrat microélectronique ayant au moins l'un d'un diélectrique poreux, d'un diélectrique à faible κ ou à κ élevé et une métallisation cuivre, le procédé comprenant de mettre en contact le substrat avec une composition de nettoyage pendant un laps de temps suffisant pour nettoyer le substrat, dans lequel la composition de nettoyage comprend :
d'environ 0,05% à 30% en poids d'une ou plusieurs base(s) forte(s) non productrice(s) d'ammoniac contenant des contre-ions chargés positivement non nucléophiles;
d'environ 0,5 à environ 99,95% en poids d'un ou plusieurs composé(s) de solvant inhibant la corrosion, le ou chaque composé de solvant inhibant la corrosion ayant au moins deux sites capable de se complexer avec des métaux ; au moins un autre co-solvant organique choisi parmi le diméthylsulfoxyde, le sulfolane, et la diméthylpipéridone dans une quantité jusqu'à environ 99,45% en poids ; et
d'environ 0 à 40% en poids d'une amine ou d'une alkanolamine à encombrement stérique ;
d'environ 0 à 40% en poids d'un acide organique ou inorganique ;
d'environ 0 à 40% en poids d'un autre composé inhibiteur de la corrosion des métaux ;
d'environ 0 à 5% en poids d'un agent tensioactif ;
d'environ 0 à 10% en poids d'un composé silicate sans ions métal ;
d'environ 0 à 5% en poids d'un agent chélateur des métaux ;
d'environ 0 à 10% en poids d'un composé fluorure ; et
de l'eau.

13. Procédé selon la revendication 12 dans lequel la base forte non productrice d'ammoniac est l'hydroxyde de tétraalkylammonium ou un sel de celui-ci.

14. Procédé selon la revendication 13 dans lequel l'hydroxyde de tétraalkylammonium ou le sel est un composé ayant la formule
[(R)₄N⁺]ₚ[X^{-q}]
où chaque R est indépendamment un groupement alkyle substitué ou non substitué ; X est OH ou un anion sel ; et p et q sont égaux et sont des entiers de 1 à 3.

15. Procédé selon la revendication 14 dans lequel R est un groupement alkyle contenant 1 à 22 atomes de carbone et X est OH ou un carbonate.

16. Procédé selon la revendication 14 dans lequel dans lequel R est un groupement alkyle de 1 à 6 atomes de carbone.

17. Procédé selon la revendication 12, 13, 14 ou 16, dans lequel le composé solvant inhibant la corrosion est un composé choisi parmi les formules :
W-(CR₁R₂)ₙ₁-X-[(CR₁R₂)ₙ₂-Y]ₓ
ou
T-[(CR₃R₄)ₘ-Z]_{y}
où W et Y sont chacun indépendamment choisis parmi =O, -OR, -O-C(O)-R, -C(O)-, -C(O)-R, -S, -S(O)-R, -SR, -S-C(O)-R, -S(O)₂-R, -S(O)₂, -N, -NH-R, -NR₁R₂, -N-C(O)-R, -NR₁-C(O)-R₂, -P(O), -P(O)-OR, et -P(O)-(OR)₂ ; X est choisi parmi un alkylène, un cycloalkylène ou un cycloalkylène contenant un ou plusieurs hétéoatomes choisis parmi les atomes de O, S, N et P, et un arylène ou un arylène contenant un ou plusieurs hétéoatomes choisis parmi les atomes de O, S, N et P ; chaque R, R₁ et R₂ sont chacun indépendamment choisis parmi l'hydrogène, un alkyle, un cycloalkyle ou un cycloalkyle contenant un ou plusieurs hétéoatomes choisis parmi les atomes de O, S, N et P, et un aryle ou un aryle contenant un ou plusieurs hétéoatomes choisis parmi les atomes de O, S, N et P ; chacun de n1 et n2 est indépendamment un entier de 0 à 6 ; et z est un entier de 1 à 6 lorsque X est un alkylène, un cycloalkylène ou un arylène ; et z est un entier de 0 à 5 lorsque X est un cycloalkylène contenant un ou plusieurs hétéoatomes choisis parmi les atomes de O, S, N et P ou un arylène contenant un ou plusieurs hétéoatomes choisis parmi les atomes de O, S, N et P ; T est choisi parmi -O, -S, -N et -P ; Z est choisi parmi l'hydrogène, -OR₅, -N(R₅)₂, et -SR₅ ; chacun de R₃, R₄ et R₅ sont chacun indépendamment choisis parmi l'hydrogène, un alkyle, un cycloalkyle ou un cycloalkyle contenant un ou plusieurs hétéoatomes choisis parmi les atomes de O, S, N et P, et un aryle ou un aryle contenant un ou plusieurs hétéoatomes choisis parmi les atomes de 0, S, N et P ; m est un entier de 0 à 6 et y est un entier de 1 à 6.

18. Procédé selon la revendication 17 lorsqu'elle est annexée à la revendication 15 dans lequel chacun de R₁ à R₅ est un groupement alkyle ayant de 1 à 6 atomes de carbone ou un groupement aryle ayant de 3 à 14 atomes de carbone.

19. Procédé selon la revendication 12, 13, 14, 15 ou 16, dans lequel le solvant inhibant la corrosion est choisi parmi l'éthylène glycol, le diéthylène glycol, le glycérol, le diéthylène glycol diméthyle éther, la monoéthanolamine, la diéthanolamine, la triéthanolamine, la N,N-diméthyléthanolamine, la 1-(2-hydroxyéthyl)-2-pyrrolidone, la 4-(2-hydroxyéthyl)morpholine, le 2-(méthylamino)éthanol, le 2-amino-2-méthyl-1-propanol, le 1-amino-2-propanol, le 2-(2-aminoéthoxy)éthanol, le N-(2-hydroxyéthyl)acétamide, le N-(2-hydroxyéthyl)succinimide et le 3-(diéthylamino)-1,2-propanediol.

20. Procédé selon la revendication 12 dans lequel la composition de nettoyage comprend de l'hydroxyde de tétraméthylammonium, de la triéthanolamine, de l'acide trans-1,2-cyclohexanediamine tétraacétique, du sulfolane et de l'eau.

21. Procédé selon la revendication 12 comprenant de l'hydroxyde de tétraméthylammonium, du diméthyle sulfoxyde, de la triéthanolamine et de l'eau.

22. Procédé selon la revendication 12 dans lequel la composition de nettoyage comprenant de l'hydroxyde de tétraméthylammonium, de la triéthanolamine, de l'éthylène glycol, de l'acide éthylènediamine tétra(méthylène phosphonique) et de l'eau.
